# Europäisches Patentamt

## European Patent Office

## Office européen des brevets

(11) Veröffentlichungsnummer: **0 015 558**
**A1**

(12) # EUROPÄISCHE PATENTANMELDUNG

(21) Anmeldenummer: **80101143.8**

(22) Anmeldetag: **06.03.80**

(51) Int. Cl.³: **H 01 R 13/53**, G 01 R 19/165, H 02 H 3/08, H 01 F 40/08, H 02 G 15/02

(30) Priorität: **08.03.79 DE 2909060**

(43) Veröffentlichungstag der Anmeldung: **17.09.80** Patentblatt **80/19**

(84) Benannte Vertragsstaaten: **AT BE CH FR GB IT LU NL SE**

(71) Anmelder: **Karl Pfisterer Elektrotechnische Spezialartikel GmbH & Co. KG, Augsburger Strasse 375, D-7000 Stuttgart 60 (DE)**

(72) Erfinder: **Schuster, Martin, Heidestrasse 51, D-7300 Esslingen (DE)**
Erfinder: **Kries, Werner, Zügernbergstrssse 28, D-7056 Weinstadt-Grossheppach (DE)**

(74) Vertreter: **Bartels, Hans, Bartels, Brandes, Held, Wolff Patentanwälte Lange Strasse 51, D-7000 Stuttgart 1 (DE)**

(54) **Isolierter Kabelstecker.**

(57) Ein isolierter Kabelstecker (1) zum Verbinden eines Kabels (3) eines Mittelspannungs- oder Hochspannungs-energieversorgungsnetzes mit einem anderen Leiter dieses Netzes, insbesondere einem sich in einer vollständig gekapselten Anlage oder einem vollständig gekapselten Gerät befindenden Leiter, weist eine kapazitiv an die Kabelseele angekoppelte Elektrode (12) sowie eine Anzeigeeinrichtung (20, 21) auf. Die Anzeigeeinrichtung ist mit einer Kurz-schluss- und/oder Überstrom-Sensoreinrichtung (17, 22, 23) zu einem Kurzschluss- und/oder Überstrommelder ver-einigt.

28. Februar 1979
Reg.-Nr. 125 868
3322rrp

Karl Pfisterer Elektrotechnische Spezialartikel GmbH & Co KG.,
7000 Stuttgart 60 (Baden-Württemberg)

## Isolierter Kabelstecker

Die Erfindung betrifft einen isolierten Kabelstecker zum
Verbinden eines Kabels eines Mittelspannungs- oder Hochspannungsenergieversorgungsnetzes mit einem anderen Leiter dieses Netzes, insbesondere einem sich in einer vollständig gekapselten Anlage oder einem vollständig gekapselten Gerät
befindenden Leiter, mit einer kapazitiv an die Kabelseele
angekoppelten Elektrode sowie einer Anzeigeeinrichtung,
insbesondere einer Anzeigeeinrichtung mit Mehrsegment-Anzeigefeld.

Es ist bekannt, einen isolierten Kabelstecker mit einer kapazitiv an die Kabelseele angekoppelten Prüfelektrode zu versehen, die von außen her zugänglich ist. Wird diese Prüfelektrode mit der Prüfspitze eines Spannungsprüfers berührt, dann
zeigt der Spannungsprüfer an, ob die Kabelseele Spannung
führt oder spannungsfrei ist. Allerdings muß darauf geachtet
werden, daß der Spannungsprüfer einen sehr hochohmigen Eingang hat, weil die Prüfelektrode nur einen äußerst geringen Strom zu liefern vermag. Werden solche Kabelstecker bei vollständig gekapselten Anlagen oder Geräten eingesetzt, bei denen die innerhalb der Kapselung liegenden Teile für eine Spannungs- oder Strommessung nicht zugänglich sind, dann kann über die Prüfelektrode des Kabelsteckers auch der Spannungszustand der im Inneren der Kapselung liegenden, an den Kabelstecker angeschlossenen Leiter geprüft werden. In manchen Fällen kann dadurch auf die relativ teuren Spannungswandler verzichtet werden. Eine Stromüberwachung, insbesondere eine Überstrom- oder Kurzschlußstromüberwachung ist aber mit diesen bekannten Kabelsteckern nicht möglich.

Letzteres gilt auch für eine nicht zum Stand der Technik gehörende Vorrichtung zur optischen Anzeige des Betriebszustandes eines isolierten Kabels eines Energieversorgungsnetzes, die an einen isolierten Kabelstecker angebaut ist. Diese Vorrichtung weist eine Spannungsanzeigeeinrichtung mit Mehrsegment-Anzeigefeld auf, die an eine kapazitiv an die Kabelseele angekoppelte Prüfelektrode angeschlossen ist und anzeigt, ob das Kabel seine Betriebsspannung führt, vom Netz abgetrennt ist und nur noch eine Ladespannung hat, kurzgeschlossen oder geerdet ist.

Da es häufig notwendig ist, einen im Netz aufgetretenen Kurzschluß in jeder Anlage anzuzeigen und die bekannten Anzeigeeinrichtungen für vollständig gekapselte Anlagen und Geräte ungeeignet sind, liegt der Erfindung, ausgehend von der Überlegung, daß eine Stromüberwachung im Bereich der Kabelstecker einen Eingriff in das Innere der Kapselung nicht erforderlich macht, die Aufgabe zugrunde, einen isolierten Kabelstecker zu schaffen, der eine Stromüberwachung ermöglicht. Mit einem isolierten Kabelstecker der eingangs genannten Art ist diese Aufgabe erfindungsgemäß dadurch gelöst,daß die Anzeigeeinrichtung mit einer am Kabel angeordneten Kurzschluß- und/oder Überstromsensoreinrichtung zu einem Kurzschluß- und/oder Überstrommelder vereinigt ist.

- 3 -                    0015558

Ein derartiger Melder, der abhängig von seiner Einstellung nur einen Kurzschlußstrom, nur einen Überstrom oder aber sowohl einen Kurzschlußstrom als auch einen Überstrom anzeigt, ermöglicht es, mit einem im Vergleich zu einem Stromwandler sehr geringen Aufwand,ständig das Netz auf Kurzschlußströme und Überströme zu überwachen, soweit diese sich auf denjenigen Bereich, in dem sich der Stecker befindet, auswirken. Von besonderem Vorteil ist hierbei, daß ein Eingriff in eine gekapselte Anlage oder ein gekapseltes Gerät nicht notwendig ist, was sowohl wegen der Leckfreiheit der Kapselung als auch wegen Störungen der Felder im Inneren der Kapselung durch von außen eingeführte Meßelemente wichtig ist.

Um auf eine Batterie als Energiequelle für den Kurzschlußmelder verzichten zu können, sieht man vorzugsweise eine LCD- Anzeige vor, die so wenig Energie benötigt, daß zumindest dann, wenn die Kapazität der Elektrode gegenüber der Kabelseele ausreichend groß gewählt ist, der von der Elektrode lieferbare Strom zum Betrieb des Kurzschlußmelders ausreicht.

Die          Sensoreinrichtung kann in verschiedener Weise ausgebildet sein. Sie kann beispielsweise einen das Kabel im Bereich des Steckers umfassenden, aus einem magnetisch leitenden Material bestehenden, offenen Ring mit einem Schalter aufweisen. Es kann dann entweder der magnetische Fluß im Luftspalt des Ringes zur Betätigung eines auf diesen Fluß ansprechenden Schalters, beispielsweise eines Reed-Kontaktschalters oder eines Halleffektschalters, oder auch die Kontraktion des Ringes im Ansprechfalle  zur Betätigung eines mechanisch betätigbaren Schalters ausgenutzt werden. Eine andere Möglichkeit der Ausbildung der          Sensoreinrichtung besteht darin, eine der Betriebsspannung entsprechende Größe zumindest für eine bestimmte Zeit zu speichern und ständig eine der augenblicklich  vom Kabel geführten Spannung entsprechende Größe mit der gespeicherten Größe zu vergleichen.Der im Kurzschlußfalle auftretende Unterschied zwischen diesen beiden Spannungen wird hierbei zur Anzeige eines

0015558

Kurzschlusses ausgenutzt.

Um die Signalwirkung der Anzeige im Anzeigefeld zu erhöhen, was besonders bei einer LCD-Anzeige wünschenswert ist, ist bei einer bevorzugten Ausführungsform eine blinkende Anzeige vorgesehen, was sich mit einfachen Mitteln, beispielsweise einem elektronischen Frequenzgeber in Form eines Flip-Flops, realisieren läßt.

Vorteilhafterweise ist zusätzlich zu der Sensoreinrichtung auch eine Spannungsprüfeinrichtung am Kabelstecker vorgesehen, damit alle wichtigen Überwachungsfunktionen ohne aufwendige Geräte, wie es Spannungswandler und Stromwandler sind, ausgeführt werden können. Vorzugsweise bedient sich die Spannungsprüfeinrichtung der kapazitiv an die Kabelseele angekoppelten Elektrode als Spannungsgeber. Damit keine ständige Anzeige erfolgt, kann zwischen der Elektrode und der Anzeigeeinrichtung ein für eine Prüfung manuell zu betätigender Schalter vorgesehen sein.

Außer der Spannungsprüfung und der Stromüberwachung ist auch immer wieder die Durchführung eines Phasenvergleiches notwendig. Bei einer bevorzugten Ausführungsform ist deshalb der Kabelstecker auch mit einer Phasenvergleichseinrichtung ausgerüstet, für welche die Vergleichsstufe des Kurzschlußmelders und die Anzeigeeinrichtung verwendet wird. Es braucht dann nur noch eine an die Vergleichsstufe/oder die Anzeigeeinrichtung des Melders angeschlossene Verbindungsleitung vorgesehen zu werden, welche zu derjenigen Stelle führt, deren Spannung hinsichtlich ihrer Phasenlage mit der Spannung des im Kabelstecker liegenden Kabels zu vergleichen ist. Der zusätzliche Aufwand ist also minimal,und vor allem kann der Phasenvergleich auch ohne weiteres bei gekapselten Anlagen oder Geräten erfolgen, weil für den Phasenvergleich nur eine Verbindung zwischen den beiden Kabelsteckern hergestellt zu werden braucht, deren Kabel hinsichtlich der Phasenlage ihrer Spannung überprüft werden sollen.

0015558

Im folgenden ist die Erfindung anhand von in der Zeichnung dargestellten Ausführungsbeispielen im einzelnen erläutert. Es zeigen:

Fig. 1 einen teilweise schematisch dargestellten Längsschnitt eines ersten Ausführungsbeipsiels,

Fig. 2 ein Blockschaltbild der dem Kabelstecker gemäß Fig. 1 zugeordneten Prüf- und Überwachungseinrichtung,

Fig. 3 ein Blockschaltbild einer mit Kabelsteckern gemäß Fig. 1 ausgerüsteten Prüf- und Überwachungseinrichtung in einer Transformatorstation,

Fig. 4 ein Blockschaltbild einer abgewandelten Ausführungsform der am Kabelstecker vorgesehenen Prüf- und Überwachungseinrichtung,

Fig. 5 ein Schaltbild eines dritten Ausführungsbeispiels eines am Kabelstecker vorgesehenen Kurzschlußmelders,

Fig. 6 einen Längsschnitt eines Kabelsteckers mit einem Kurzschlußmelder gemäß Fig. 5.

Ein als Ganzes mit 1 bezeichneter, isolierter Kabelstecker, der in eine als Ganzes mit 2 bezeichnete Steckbuchse einführbar ist, dient zum Verbinden eines kunststoffisolierten Kabels 3 eines Mittelspannungs-Energieversorgungsnetzes mit einem nicht dargestellten Leiter dieses Netzes, bei dem es sich beispielsweise um eine Sammelschiene oder um ein Kontaktstück eines Schalters handeln kann. Dieses Kontaktstück od. dgl. befindet sich im Ausführungsbeispiel innerhalb eines vollständig geschlossenen und beispielsweise mit $SF_6$-Gas gefüllten Gehäuses, von dem nur ein Teil seiner Gehäusewand 4 dargestellt ist.

In eine Öffnung der Gehäusewand 4 ist gasdicht die Steckbuchse 2 eingesetzt, in deren becherförmigem, elektrisch
isolierendem Gehäuse 5 sich der Steckbuchsenkörper 6 befindet, der am einen Ende eines gasdicht durch den Boden des
Gehäuses 5 hindurchgeführten Verbindungsbolzen sitzt.

Der in den Steckbuchsenkörper 6 eingreifende Steckerkörper 7
des Kabelsteckers 1 sitzt klemmend auf dem abisolierten Endabschnitt des Kabels 3. Auf den sich anschließenden, freigelegten Abschnitt der Kabelisolation ist eine Dichtungshülse
8 aus einem weichen, isolierenden Gummi aufgeschoben, deren
dem Steckerkörper 7 abgekehrtes Ende einen Außenkonus bildet, welcher in einen korrespondierend ausgebildeten Innenkonus eines Feldabsteuerungskörpers 9 eingreift. Dieser Feldabsteuerungskörper 9 liegt an der die Kabelisolation bedekkenden, leitenden Schicht an und übergreift den Endabschnitt
der Kabelummantelung sowie die Abschirmungsdrähte 10, die am
hinteren Ende des elektrisch isolierenden Steckergehäuses 11
zwischen diesem und der Kabelummantelung herausgeführt sind.

Zwischen das konische Ende der Dichtungshülse 8 und das konische Ende des Feldabsteuerungskörpers 9 ist eine an diese
beiden Konen angepasste, das Kabel 3 ringförmig umfassende
Ankoppelungselektrode 12 gelegt, von der aus eine Verbindungsleitung 13 aus dem Steckergehäuse 11 herausgeführt ist. Im
Ausführungsbeispiel verläuft die Verbindungsleitung 13 zunächst zwischen der Außenmantelfläche des Feldabsteuerungskörpers 9 und der Innenmantelfläche des Steckergehäuses 11,
sodann zwischen der Außenmantelfläche des Kabels 3 und der
Innenmantelfläche des Feldabsteuerungskörpers 9 bzw. des
Steckergehäuses 11.

Die Verbindungsleitung 13 ist zu einem kleinen Steckbuchsensockel 14 geführt, der außen am Kabelstecker 1 fest angeordnet ist. Im Ausführungsbeispiel wird er zusammen mit einem
Drucktastenschalter 15 von einer Lasche 16 getragen, die fest
mit einer außen am Steckergehäuse 11 festgelegten Induktionsspule 17 verbunden ist. Die Anordnung dieser Induktionsspule 17 ist so getroffen, daß sie von dem Feld, das ein im Kabel 3 fließender Strom erzeugt, durchsetzt wird. Selbstverständlich wäre es möglich, den Steckersockel 14, den Drucktastenschalter 15 und die Induktionsspule 17 in anderer Weise mit dem Steckergehäuse 11 zu verbinden. Beispielsweise könnten diese Teile in Vertiefungen des Steckergehäuses eingreifen oder alle auf einer vom Steckergehäuse gebildeten Montagefläche befestigt sein.

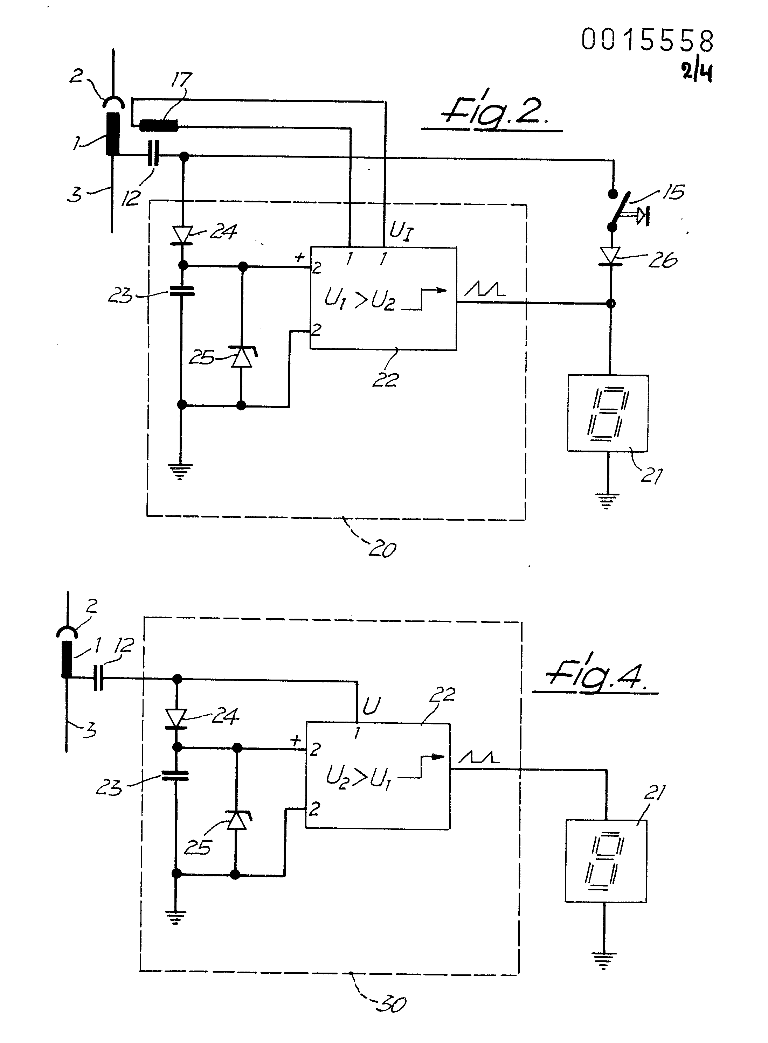

In den Steckbuchsensockel 14, zu dem außer der Verbindungsleitung 13 auch die beiden Zuleitungen der Induktionsspule 17 sowie eine an die Abschirmdrähte 10 angeschlossene Masseleitung führen, werden die Kontaktstifte eines Gehäuses 20 eingesetzt, das, im Ausführungsbeispiel auf der dem Steckbuchsensockel 14 abgekehrten Seite, ein LCD-Anzeigenfeld trägt. Im Inneren des in Fig. 2 durch gestrichelte Linien schematisch angedeuteten Gehäuses 20 sind ein IC-Baustein 22, ein Speicherkondensator 23 sowie zwei Dioden 24 und 25 angeordnet.

Der Speicherkondensator 23 wird, da/einerseits über die Diode 24 mit der Ankoppelungselektrode 12 und andererseits mit Masse verbunden ist, auf seiner maximalen Ladespannung gehalten, solange das Kabel 3 seine Betriebsspannung führt. Die Ladespannung des Speicherkondensators 23, zu dem parallel die Diode 25 geschaltet ist, liegt am zweiten Eingang des IC-Bausteins 22 an, der dann ein Signal in Form einer Folge von Impulsen abgibt, wenn die an seinem ersten Eingang anliegende Spannung größer ist als diejenige am zweiten Eingang. Mit dem ersten Eingang ist die Induktionsspule 17 verbunden, die so bemessen ist, daß die in ihr durch den Strom im Kabel 3 induzierte Spannung nur dann größer ist als die Ladespannung des Speicherkondensators 23, wenn der Strom den vorgegebenen Grenzwert übersteigt. Dieser Grenzwert kann so gewählt werden, daß nur ein Kurzschlußstrom zu einem Ausgangssignal des IC-Bausteins 22 führt. Es ist aber auch möglich, bereits durch einen Überstrom ein Ausgangssignal am IC-Baustein 22 zu erzeugen.

Der IC-Baustein 22 gibt, nachdem die Ansprechbedingung erfüllt worden ist, solange Ausgangssignale ab, als er die hierzu erforderliche Energie vom Speicherkondensator 23 erhält. Diese Zeit hängt von der Größe des Speicherkondensators 23 und der maximalen Ladespannung ab, die mittels der Diode 25 gewählt worden ist.

Der Ausgang des IC-Bausteins 22 ist mit dem Eingang einer dem LCD-Anzeigefeld 21 vorgeschalteten, nicht dargestellten Dekodier- und Treiberstufe verbunden. Das Symbol, das auf dem Anzeigefeld 21 erscheint, wenn am Ausgang des IC-Bausteins 22 Signale auftreten, kann in weiten Grenzen frei gewählt werden. Beispielsweise kann das Blitz-Symbol dargestellt werden. Da die Ausgangssignale des IC-Bausteins 22 Impulse sind, blinkt das LCD-Anzeigefeld 21 im Rhytmus der Impulsfrequenz, wodurch die Anzeige mehr auffällt und damit besser beachtet wird.

Der Drucktastenschalter 15, der in Reihe mit einer dritten Diode 26 liegt, ist einerseits mit dem Eingang des LCD-Anzeigefeldes 21, andererseits mit der Ankoppelungselektrode 12 verbunden. Liegt das Potential der Ankopplungselektrode 12 am Eingang der Dekodierstufe des LCD-Anzeigefeldes 21 an, dann wird auf letzterem der Spannungszustand des Kabels angezeigt. Sieht man zwischen der Ankoppelungselektrode 12 und der Dekodierstufe des LCD-Anzeigefeldes eine Eingangsschaltung vor, welche unterschiedliche Signale abgibt, je nachdem, ob das Kabel seine Betriebsspannung führt, nur noch eine Ladespannung hat oder spannungslos ist, dann kann durch eine Betätigung des Drucktastenschalters 15 der Betriebszustand des Kabels 3 auf dem LCD-Anzeigefeld 21 zur Anzeige gebracht werden. Die dritte Diode 26 verhindert, daß bei spannungslosem Kabel die Ankoppelungselektrode 12 durch die Ausgangssignale des IC-Bausteins 22 aufgeladen wird.

Selbstverständlich wäre es auch möglich, die Kurzschluß- oder Überstromanzeige einerseits und die Anzeige des Spannungszustandes des Kabels andererseits mit zwei separaten LCD-An-

zeigefeldern / durchzuführen, die auch zu einer Einheit zusammengefasst sein könnten. In diesem Falle wäre der Ausgang des IC-
Bausteins 22 mit einem ersten Eingang und der Drucktastenschalter 15 mit einem zweiten Eingang der Anzeigeeinheit verbunden.

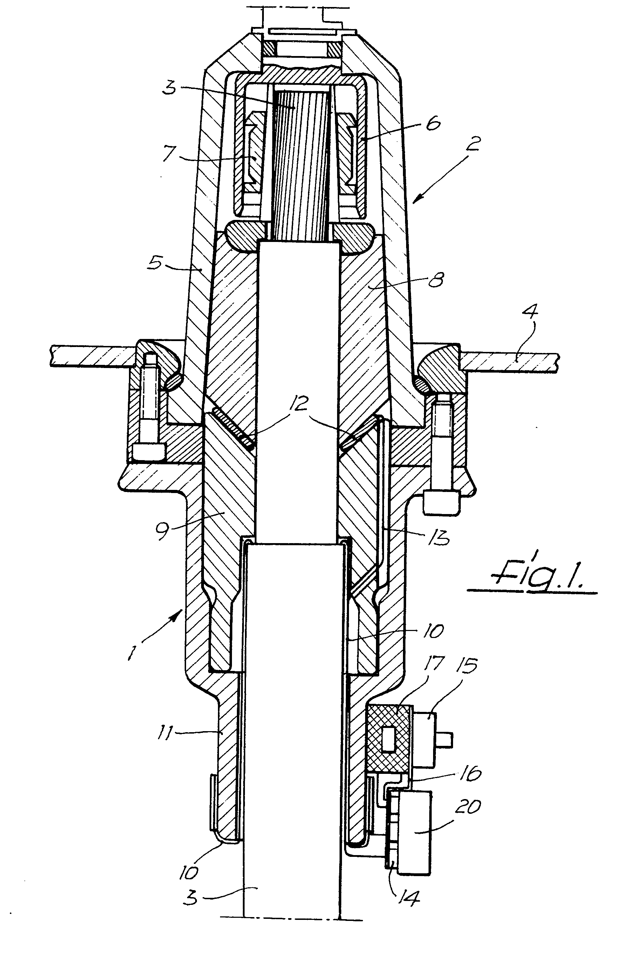

Fig. 3 zeigt, wie ein Kabelstecker gemäß den Fig. 1 und 2
beispielsweise in einer Transformatorstation eingesetzt werden kann, zu der zwei Leitungssysteme führen. Üblicherweise
bilden diese beiden Leitungssysteme Teilabschnitte einer
Ringleitung, die in der Transformatorstation aufgetrennt werden kann. Hierzu sind in der Transformatorstation Sammelschienen vorgesehen, an welche sowohl die beiden Systeme als
auch der Transformator über die Kabelstecker anschließbar ist.

Jede Phase der beiden drehphasigen Kabelsysteme ist, wie Fig.3
zeigt, mit einem der Kabelstecker 1 ausgerüstet, der, wie vorstehend beschrieben, mit einem Kurzschlußmelder und einer
Spannungsprüfeinrichtung versehen ist. Die Kabelstecker 27,
über die der Transformator mit den Kabelsystemen verbindbar
ist, tragen hingegen nur die Spannungsprüfeinrichtung, von
der in Fig. 3 das LCD-Anzeigefeld 21 und der Drucktastenschalter 15 dargestellt ist.

Um in der Transformatorstation nicht nur den Betriebszustand
der Kabel und des Transformators prüfen sowie einen eventuell
aufgetretenen Kurzschluß oder einen eventuell aufgetretenen
Überstrom anzeigen zu können, sondern auch die Möglichkeit
zu haben, einen Phasenvergleich durchzuführen, ist der zweite
Eingang jedes LCD-Anzeigefelds 21 nicht ständig auf Massepotential gelegt. Vielmehr sind alle diese zweiten Eingänge miteinander verbunden und an einen Umschalter 28 angeschlossen,
der in seiner einen Schaltstellung offen ist und in seiner
anderen Schaltstellung alle diese zweiten Eingänge mit Masse
verbindet. In die letztgenannte Schaltstellung wird der Umschalter 28 gebracht, wenn eine Spannungsprüfung durchzuführen ist. Für einen Phasenvergleich wird der Umschalter 20 in
seine offene Schaltstellung umgelegt.

Es     brauchen nun nur diejenigen beiden Drucktastenschalter 15 betätigt zu werden, deren beide zugeordneten Kabel hinsichtlich Phasengleichheit oder Phasenungleichheit geprüft werden sollen.

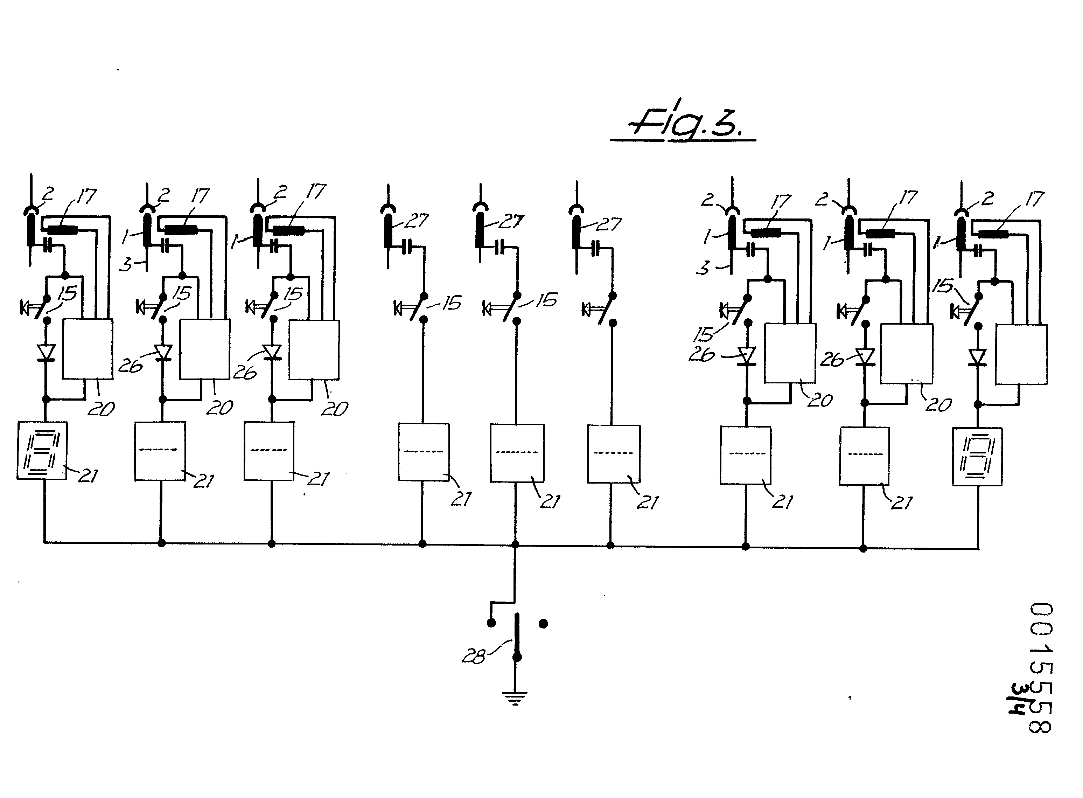

Sofern nur eine Kurzschlußanzeige und nicht auch eine Überstromanzeige erforderlich ist, kann der Kabelstecker 1 anstelle eines Kurzschlußmelders, wie ihn Fig. 2 zeigt, auch beispielsweise mit einem als Ganzes mit 30 bezeichneten Kurzschlußmelder ausgerüstet sein, wie ihn Fig. 4 zeigt. Der Kurzschlußmelder 30 nutzt für eine Kurzschlußanzeige den bei einem Kurzschluß auftretenden Zusammenbruch der Spannung aus. Er ist daher wie der Kurzschlußmelder gemäß Fig. 2 mit dem IC-Baustein 22 ausgerüstet, welcher ständig die Betriebsspannung des Kabels mit dem Sollwert der Betriebsspannung vergleicht und dann, wenn die Betriebsspannung über einen bestimmten Wert unter die Sollspannung abgesunken ist, ein Signal erzeugt, das wie bei dem Kurzschlußmelder gemäß Fig. 2 aus einer Folge von Impulsen besteht, damit die Anzeige auf dem nachgeschalteten LCD-Anzeigefeld 21 blinkt. Als tatsächliche Betriebsspannung des Kabels wird das an der Ankoppelungselektrode 12 des Kabelsteckers liegende Potential auf den einen Eingang des IC-Bausteins 22 gegeben. Am anderen Eingang liegt die Ladespannung des Speicherkondensators 23 an, der einerseits über die Diode 24 mit der Ankoppelungselektrode 12 und andererseits mit Masse, also der Abschirmung des Kabels, verbunden ist. Parallel zum Speicherkondensator 23 liegt die Diode 25, mittels deren die Ladespannung des Speicherkondensators begrenzt werden kann. Der Speicherkondensator 23 ist normalerweise auf die gewünschte Ladespannung aufgeladen. Bricht nun infolge eines Kurzschlusses die vom Kabel geführte Spannung zusammen, dann bleibt zunächst die Ladespannung des Speicherkondensators 23 unverändert. Damit ist die Voraussetzung für das Auftreten einer Impulsfolge am Ausgang des IC-Bausteins 22 erfüllt. Die Zeit, während deren eine blinkende Anzeige im LCD-Anzeigefeld 21 erfolgt, ist davon abhängig, wieviel Energie der Speicherkondensator 23 an den IC-Baustein 22 abgeben kann. Beispielsweise kann die Dauer der Anzeige durch entsprechende Wahl der Ladespannung des Speicherkondensators 23 zwischen 30 Minuten und 2 Stunden frei gewählt werden. Man kann daher die Anzeigedauer so wählen, daß einerseits die Anzeige nicht erlischt, ehe eine Kontrollperson nach einem Kurzschluß an der Transformatorstation od.dgl. eintreffen kann,und andererseits sichergestellt ist, daß nach einer bestimmten Zeit die Anzeige selbsttätig wieder erlischt und damit der Kurzschlußmelder erneut einsatzbereit ist.

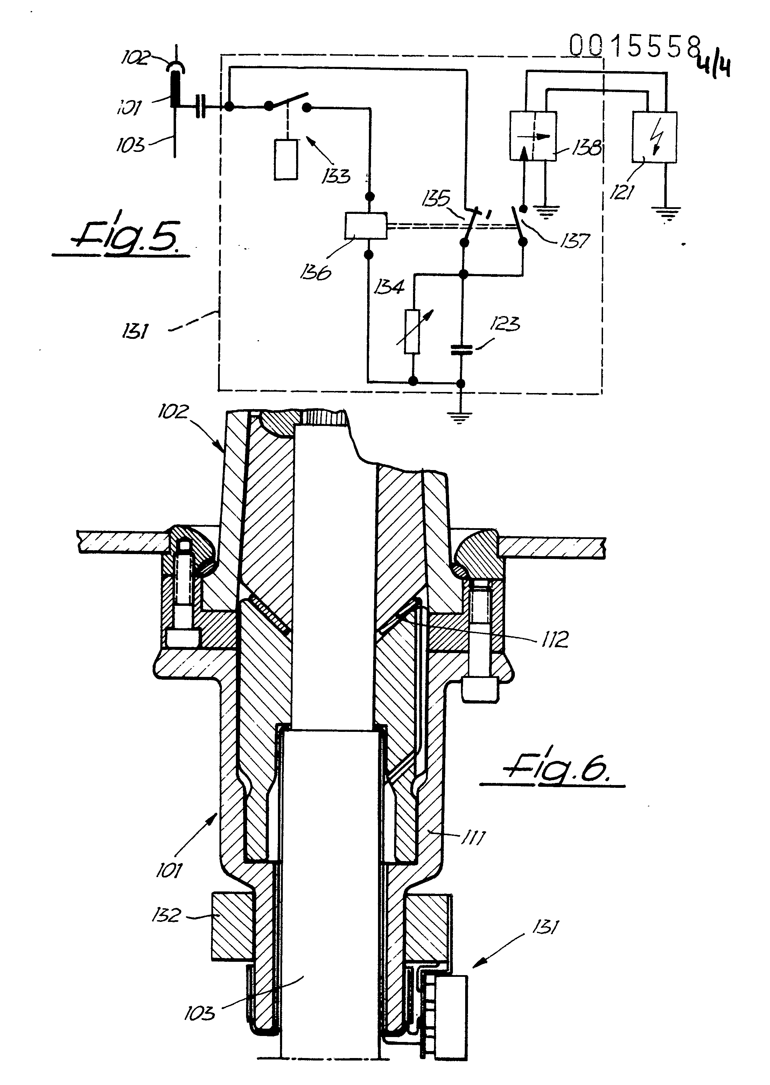

Der Kabelstecker 101 des Ausführungsbeispiels gemäß den Fig. 5 und 6 hat, wie Fig. 1 zeigt, im wesentlichen die gleiche konstruktive Ausbildung wie der Kabelstecker 1 des Ausführungsbeispiels gemäß den Fig. 1 bis 4. Im folgenden sind daher nur die Unterschiede erwähnt. Im übrigen wird auf die Ausführungen zu dem ersten Ausführungsbeispiel Bezug genommen.

Der wesentliche Unterschied gegenüber dem Kabelstecker 1 besteht in der Ausbildung des als Ganzes mit 131 bezeichneten Kurzschlußmelders, der auch so eingestellt werden kann, daß er einen Überstrom anzeigt. Der Sensor des Kurzschlußmelders 131 weist einen offenen Ring 132 aus einem ferromagnetischen Material auf, der den Kabelstecker und das zugehörige Kabel 103 umfasst, und zwar im Ausführungsbeispiel in dem im Durchmesser etwas verkleinerten, hinteren Endabschnitt des Steckergehäuses 111. Zwischen die beiden Ringenden ist beispielsweise ein Reed-Kontaktschalter 133 gelegt, der so eingestellt ist, daß der magnetische Fluß im Luftspalt des Ringes 132 erst dann ausreicht, um den Reed-Kontaktschalter 133 zu schließen, wenn ein bestimmter Wert des im Kabel fließenden Stromes überschritten wird. Statt des Reed-Kontaktschalters 133 könnte aber auch beispielsweise ein Halleffektschalter vorgesehen sein, also ein kontaktloser Schalter, der den Halleffekt ausnutzt. Ferner wäre es beispielsweise möglich, den offenen Ring 132 in der Art eines Hufeisenmagneten auszubilden und zwischen den Schenkelenden einen drehbaren oder translatorisch bewegbaren Anker anzuordnen, der durch seine Bewegung einen Schalter betätigt. Ebenso wäre es beispielsweise möglich, die Kontraktion des offenen Ringes 132 im Kurzschlußfalle für eine Betätigung eines Schalters auszunutzen.

Wie Fig. 5 zeigt, weist der Kurzschlußmelder 131 einen Speicherkondensator 123 auf, der einerseits mit der Ankoppelungselektrode 112 verbunden ist und andererseits über die Abschirmung des Kabels auf Massepotential liegt. Parallel zum Speicherkondensator 123 ist ein verstellbarer Entladewiderstand 134 geschaltet, mittels dessen die Entladezeit des Speicherkondensators 123 eingestellt werden kann. Im Ladestromkreis des Speicherkondensators 123, also zwischen diesem und der Ankoppelungselektrode 112, liegt ein erster Schalter 135 eines Zeitgliedes 136, das einen zweiten Schalter 137 aufweist, über den die Ladespannung des Speicherkondensators an den Eingang einer Kippstufe 138 anlegbar ist, die Ausgangssignale in Form einer Impulsfolge erzeugt, wenn die Eingangspannung oberhalb eines Grenzwertes liegt. An den Ausgang der Kippstufe 138 ist ein LCD-Anzeigefeld 121 angeschlossen, dessen Dekodierschaltung und Treiberstufe nicht dargestellt sind. Das Zeitglied 136 liegt einerseits auf Erdpotential und ist andererseits über den Reed-Kontaktschalter 133 mit der Ankoppelungselektrode 112 verbunden.

Fließt über das Kabel 103 ein Kurzschlußstrom oder ein Überstrom, dann spricht die im Ausführungsbeispiel aus dem offenen Ring 132 und dem Reed-Kontaktschalter 133 bestehende Sensoreinrichtung zumindest kurzzeitig an. Die Folge ist, daß der erste Schalter 135 des Zeitgliedes 136 geöffnet und der zweite Schalter 137 geschlossen wird. Auch wenn der Reed-Kontaktschalter 133 nur kurzzeitig geschlossen wird, hält das Zeitglied 136 für eine wählbare Zeitspanne, die beispielsweise im Bereich zwischen 30 Minuten und 2 Stunden liegen kann, die beiden Schalter 135 und 137 in dieser Position, in welcher der Speicherkondensator 123 von der Ankoppelungselektrode 112 abgetrennt und seine Ladespannung an den Eingang der Kippstufe 138 gelegt ist. Die Folge ist daher eine blinkende Anzeige des LCD-Anzeigefeldes 121. Diese blinkende Anzeige erfolgt solange, als der Speicherkondensator eine für die Triggerung der Kippstufe noch ausreichende Ladespannung hat. Wie schnell diese Ladespannung absinkt, hängt von der Einstellung des Entladewiderstandes 134 ab. Nach der vorgewählten Zeit kehrt das Zeitglied 136 wieder in seine Ausgangslage zurück, in der der erste Schalter 135 geschlossen und der zweite Schalter 137 geöffnet ist. Der Kondensator 123 wird nunmehr wieder aufgeladen und der gesamte Kurzschlußmelder hat sich selbsttätig wieder für die Anzeige eines erneuten Kurzschlusses oder Überstromes bereitgemacht.

Selbstverständlich kann der Kabelstecker 101 ebenso wie der Kabelstecker 1 zusätzlich zu dem Kurzschlußmelder eine Spannungsprüfeinrichtung sowie eine Phasenprüfeinrichtung aufweisen, die wie die entsprechenden Einrichtungen des ersten Ausführungsbeispiels ausgebildet sein könnten.

Patentansprüche

1.      Isolierter Kabelstecker zum Verbinden eines Kabels eines Mittelspannungs- oder Hochspannungsenergieversorgungsnetzes mit einem anderen Leiter dieses Netzes, insbesondere einem sich in einer vollständig gekapselten Anlage oder einem vollständig gekapselten Gerät befindenden Leiter, mit einer kapazitiv an die Kabelseele angekoppelten Elektrode sowie einer Anzeigeeinrichtung,
dadurch gekennzeichnet, daß die Anzeigeeinrichtung (21;121) mit einer Kurzschluß- und/oder Überstrom-Sensoreinrichtung (17,22,23;132,133) zu einem Kurzschluß-und/oder Überstrommelder (17,21,22,23;30;131) vereinigt ist.

2.      Kabelstecker nach Anspruch 1, dadurch gekennzeichnet, daß die Kurzschluß- und/oder Überstromsensoreinrichtung (132,133) einen das Kabel umfassenden, aus einem magnetisch leitenden Material bestehenden, offenen Ring (132) mit einem Schalter (133) aufweist.

3.      Kabelstecker nach Anspruch 2, dadurch gekennzeichnet, daß der Schalter als Reed-Kontaktschalter (133), als Halleffektschalter  oder als mechanisch zu betätigender Schalter mit einem von den relativ zueinander bewegbaren Ringenden oder einem durch den magnetischen Fluß im Ring (132) bewegbaren  Betätigungsglied ausgebildet ist.

4.      Kabelstecker nach Anspruch 1, dadurch gekennzeichnet, daß die Kurzschluß- und/oder Überstromsensoreinrichtung (17,21,22,23) eine an das Kabel (3) angekoppelte Induktionsspule (17), ein Speicherglied (23), das mindestens für eine vorbestimmte Zeit eine der Betriebsspannung des Kabels entsprechende Größe speichert, sowie eine Vergleichsstufe (22) aufweist.

5.      Kabelstecker nach Anspruch 4, dadurch gekennzeichnet, daß das Speicherglied ein an die Elektrode (12) angeschlossener oder anschließbarer Kondensator (23) ist.

6.        Kabelstecker nach einem der Ansprüche 1 bis 5, dadurch gekennzeichnet, daß der Anzeigeeinrichtung (21;121)ein eine blinkende   Anzeige bewirkendes Frequenzglied (22;138) zugeordnet ist.

7.        Kabelstecker nach einem der Ansprüche 1 bis 6, dadurch gekennzeichnet, daß zusätzlich zu der Kurzschluß- und/oder Überstromsensoreinrichtung (17,21,22,23;30;131) eine Spannungsprüfeinrichtung (12,15,21) vorgesehen ist.

8.        Kabelstecker nach Anspruch 7, dadurch gekennzeichnet, daß die Spannungsprüfeinrichtung die kapazitiv an die Kabelseele angekoppelte Elektrode (12) als Geberelement aufweist und daß zwischen dem Geberelement und der Anzeigeeinrichtung (21) ein für eine Prüfung manuell zu betätigender Schalter (15) liegt.

9.        Kabelstecker nach einem der Ansprüche 1 bis 8, dadurch gekennzeichnet, daß die der Kurzschluß- und/oder Überstromsensoreinrichtung (17,22;132,133) und/oder dem Spannungsgeberelement (12;112) nachgeschaltete Anzeigeeinrichtung ein LCD-Anzeigefeld (21;121) aufweist und daß als Energiequelle der mittels der kapazitiv an die Kabelseele angekoppelten Elektrode (12;112) gebildete Kondensator und/oder ein Energiespeicher (23;123) vorgesehen ist.

10.        Kabelstecker nach Anspruch 9, dadurch gekennzeichnet, daß der Energiespeicher ein mit der Elektrode (12; 112) über eine Diode (24) verbundener Kondensator (23) ist.

11.        Kabelstecker nach einem der Ansprüche 1 bis 10, gekennzeichnet durch eine Phasenvergleichseinrichtung (21,22, 28), welche die Vergleicherstufe (22) des Kurzschlußmelders, die Anzeigeeinrichtung (21) sowie eine an die Vergleicherstufe oder die Anzeigeeinrichtung angeschlossene Verbindungsleitung aufweist, welche zu derjenigen Stelle führt, deren Spannung hinsichtlich deren Phasenlage mit der Spannung des im Kabelstecker (1) liegenden Kabelendes zu vergleichen ist.

12. Kabelstecker nach Anspruch 11, dadurch gekennzeichnet, daß die Verbindungsleitung über einen manuell betätigbaren Schalter (28) mit Erdpotential verbunden ist.

- . -

Fig.1.

Fa. Karl Pfisterer · · · · ·

Reg.-Nr. 125 868

Fig.2.

$U_1 > U_2$

$U_I$

Fig.4.

$U_2 > U_1$

$U$

Fa. Karl Pfisterer ·····

Reg.-Nr. 125 868

Fig.3.

Fa. Karl Pfisterer

Reg.-Nr. 125 868

0015558
3/4

001558 4/4

_Fig.5._

_Fig.6._

_Fa. Karl Pfisterer_ . . . . .

Reg.-Nr. 125 868

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | US - A - 3 657 650 (ARNDT) <br> * Spalte 2, Zeile 15 bis Spalte 3, Zeile 74; Spalte 4, Zeile 44 bis Spalte 5, Zeile 4; Fig. 1 bis 6 * <br> -- | 1-4, 7-9 |
| | DE - A1 - 2 513 006 (SCHALTBAU) <br> * Ansprüche 1 und 5 * <br> -- | 1-3, 6,9 |
| | FUNKSCHAU, Band 50, Nr. 8, 1978, München <br> J. KÖLBL "Reedkontakt-Sicherung" <br> Seiten 369 bis 370 <br> * Seite 369, linke Spalte, Zeile 1 bis mittlere Spalte, Zeile 15 * <br> -- | 3 |
| A | US - A - 3 513 394 (TACHICK) <br> * Spalte 2, Zeilen 38 bis 59; Spalte 3, Zeilen 20 bis 48; Fig. 1 * <br> -- | |
| A | DE - A - 1 615 054 (WESTINGHOUSE) <br> * Ansprüche 3,6,7,8; Fig. 1 und 3 * <br> -- | |
| A | DE - A1 - 2 409 990 (SIEMENS) <br> * Ansprüche 1 bis 6; Fig. 1 * <br> ---- | |

**KLASSIFIKATION DER ANMELDUNG (Int.Cl.3)**

H 01 R 13/53
G 01 R 19/165
H 02 H 3/08
H 01 F 40/08
H 02 G 15/02

**RECHERCHIERTE SACHGEBIETE (Int. Cl.3)**

G 01 R 19/165
G 08 B 19/00
G 08 B 21/00
H 01 F 40/04
H 01 F 40/06
H 01 F 40/08
H 01 R 13/52
H 01 R 13/53
H 02 B 1/18
H 02 B 11/10
H 02 G 15/02
H 02 H 3/08

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X Der vorliegende Recherchenbericht wurde für alle Patentansprüche erstellt.

| Recherchenort <br> Berlin | Abschlußdatum der Recherche <br> 16-06-1980 | Prüfer <br> HAHN |
|---|---|---|